Europäisches Patentamt

European Patent Office

Office européen des brevets

(19)

(11) **EP 1 519 410 A1**

(12) **EUROPEAN PATENT APPLICATION**

(43) Date of publication:
**30.03.2005 Bulletin 2005/13**

(51) Int Cl.7: **H01L 21/768**, H01L 23/48

(21) Application number: **03447236.5**

(22) Date of filing: **25.09.2003**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Beyne, Eric**<br>**3001 Leuven (BE)** |
| (71) Applicant: **Interuniversitair Microelektronica Centrum vzw ( IMEC)**<br>**3001 Leuven (BE)** | (74) Representative: **Van Malderen, Joelle et al**<br>**Office Van Malderen,**<br>**Place Reine Fabiola 6/1**<br>**1083 Bruxelles (BE)** |

(54) **Method for producing electrical through hole interconnects and devices made thereof**

(57)  The present invention is related to a method for the fabrication of a device comprising electrical through hole interconnects, comprising the following steps:

(A) providing a substrate (1),
(B) dry etching said substrate (1), forming at least one substrate hole (2),
(C) depositing a first layer of a first patternable dielectric material (3) on said substrate, said substrate hole (2) thereby being filled,
(D) anisotropically dry etching in said first layer of patternable dielectric material (3) within said substrate hole (2), forming at least one dielectric hole (4) within said substrate hole (2), whereby the sidewalls of said substrate hole (2) remain covered with said first layer of a first patternable dielectric material (3), until the bottom of said substrate hole (2) is reached,
(E) depositing a layer of conducting material (5) on the bottom and on the sidewalls of said dielectric hole (4), thereby transforming said dielectric hole (4) into a conductor hole.
(F) depositing a second layer of a second patternable dielectric material (6) on top of said layer of conducting material (5), said conductor hole being filled.

Fig. 1

## Description

### Field of the invention

The present invention is related to the field of electrical interconnection technologies for microelectronics system elements. In particular the present invention is related to methods for producing electrical through hole interconnects.

### State of the art

The evolution of VLSI technology asks for an increasing bandwidth of interconnects between IC's and/or other system elements. For short interconnects electrical signal lines maintain the highest capacity and speed. In order to keep up with the increasing speed and density requirements, system in a package (SIP) technology is increasingly used. This creates the need for 3-dimensional interconnects.

An example of the fabrication of such interconnects can be found in patent US-B-6184060. Vias or through holes are made in the front side of the wafer, and dielectric and contact pad metal are deposited into the vias. Then the wafer back side is etched until the back metal is exposed. This method requires the back side etching up until the contact pad, including etching the dielectric deposited on the bottom of the vias. The patent indicates Silicon oxide or BPSG as material for the dielectric, deposited by CVD (Chemical Vapour Deposition). Also thermal oxidation is mentioned. Etching Silicon oxide with respect to silicon is not trivial and cannot be done anistropically. Silicon oxide deposition produces layers with essentially uniform thickness, which limits design freedom.

### Aims of the invention

The present invention aims to provide a novel method for producing via or through hole interconnects between microelectronic elements, which is relatively easy to perform and can be applied relatively cheaply compared to the state of the art. The method should for instance be applicable in thin chip technology as MCM (Multi Chip Module) and system in a package (SIP) technology.

### Summary of the invention

In a first aspect the invention relates to a method for the fabrication of a device comprising electrical through hole interconnects, comprising the following steps:

(A) providing a substrate,
(B) dry etching said substrate, forming at least one substrate hole,
(C) depositing a first layer of a first patternable dielectric material on said substrate, said substrate hole (2) thereby being filled,
(D) anisotropically dry etching in said first layer of patternable dielectric material within said substrate hole, forming at least one dielectric hole within said substrate hole, whereby the sidewalls of said substrate hole remain covered with said first layer of a first patternable dielectric material, until the bottom of said substrate hole is reached,
(E) depositing a layer of conducting material on the bottom and on the sidewalls of said dielectric hole, thereby transforming said dielectric hole into a conductor hole,
(F) depositing a second layer of a second patternable dielectric material on top of said layer of conducting material, said conductor hole being filled.

Preferably at least two of said dielectric holes within the same substrate hole define interconnects, between which a predetermined electromagnetic field is created when they carry a signal.

The dielectric holes within the same substrate hole can define an N-fold coaxial cable interconnect. Typically N equals 2.

Advantageously the method further comprises a step of

(G) dry etching said substrate from the backside, until said conducting material is reached.

The invention also relates to a method for the fabrication of a device comprising electrical through hole interconnects, comprising the steps of

- performing the method as described above on the front side of said substrate, forming at least one substrate hole in said front side, and
- performing the method on the back side of said substrate, forming at least one substrate hole in said back side, said substrate hole in said back side being aligned with said substrate hole in said front side, thereby producing isolated through hole interconnects passing from said front side of said substrate to said backside of said substrate.

Advantageously the method further comprises the steps of:

(I) anisotropically dry etching in a previous layer of patternable dielectric material within a previous conductor hole formed by a previous layer of conductive material, forming at least one dielectric hole within said previous conductor hole, whereby the sidewalls of said previous conductor hole remain covered with said previous layer of patternable dielectric material, until the bottom of said previous conductor hole is reached,
(J) depositing a next layer of conducting material on the bottom and on the sidewalls of said dielectric hole in said previous layer of patternable dielectric material, thereby transforming said dielectric hole into a conductor hole,

(K) depositing a next layer of a further patternable dielectric material on top of said next layer of conducting material, said conductor hole thereby being filled.

Method according to claim 1, further comprising the steps of:

(L) anisotropically dry etching in a previous layer of patternable dielectric material within a previous conductor hole formed by a previous layer of conductive material, forming at least one dielectric hole within said previous conductor hole, whereby the sidewalls of said previous conductor hole remain covered with said previous patternable dielectric material, until the bottom of said previous conductor hole is reached,

(M) removing said conducting material from the bottom of said dielectric hole until said substrate is exposed on the bottom of said dielectric hole,

(N) depositing a next layer of a further patternable dielectric material, whereby said dielectric hole is filled,

(O) anisotropically dry etching in said next layer of patternable dielectric material within said dielectric hole, forming a new dielectric hole within said dielectric hole, whereby the remains of said dielectric hole remain covered with said next layer of patternable dielectric material, until the bottom of said substrate hole is reached,

(P) depositing a next layer of conducting material on the bottom and on the sidewalls of said new dielectric hole in said next layer of patternable dielectric material, thereby transforming said new dielectric hole into a conductor hole,

(Q) depositing a next layer of a further patternable dielectric material on top of said next layer of conducting material.

In an advantageous embodiment the method reapplies the further steps (I,J,K) for a finite number of times and the backside of said substrate (1) optionally is thinned up until a level (LA) high enough such that the conducting material on the bottom of said layers of conducting material is removed.

Alternatively the method reapplies the further steps (L,M,N,O,P,Q) for a finite integer number of times and whereby optionally the backside of said substrate is thinned up until a level (LB) high enough such that the conducting material on the bottom of said layers of conducting material is removed.

The conducting material (5) preferably is copper.

Any of the steps (E), (J) or (P) typically creates an interconnection with an external contact.

The first, the second and further dielectric materials are chosen from the group [polymer, silicone]. Advantageously the polymer is benzocyclobutene. Said dielectric materials preferably are deposited by spin coating or spray coating or lamination. More preferably they are the same dielectric material.

The substrate preferably is a processed substrate and more preferably a semiconductor substrate. Most preferably it is a silicon substrate.

In a specific embodiment the substrate hole is circular shaped. Said dielectric hole is circular or ring shaped. The dielectric hole and said substrate hole preferably are concentric. The width of said dielectric hole (4) is between 15 $\mu$m and 40$\mu$m.

Patterning of the patternable dielectric material typically is performed by plasma-etching or lithography techniques.

The present invention also relates to chip to wafer bonding and more specifically to an interconnect scheme for already bonded chips. This method for the fabrication of a device comprising electrical through hole interconnects comprises the steps of:

I) providing a substrate, typically covered by an oxide layer and comprising an open contact,

J) bonding a silicon die to said substrate, whereby said silicon die has an internal contact or an internal contact is created, said internal contact being isolated by a first layer of a first dielectric material,

K) thinning said bonded silicon die without revealing said internal contact,

L) dry etching said silicon die, forming at least one substrate hole, until said first layer of said first dielectric material in said internal contact is reached,

M) dry etching said first layer of said first dielectric material at the bottom of said substrate hole,

N) depositing a second layer of a second dielectric material, said substrate hole thereby being filled,

O) depositing and patterning a thin Aluminium hardmask layer, and dry etching in said second layer of said second dielectric material within said substrate hole in said silicon die, forming a dielectric hole within said substrate hole, whereby the sidewalls of said substrate hole remain covered with said second layer of said second dielectric material, until the bottom of said substrate hole is reached,

P) depositing a thick Aluminium layer, creating an interconnect between said open contact and said internal contact, thereby transforming said dielectric hole into a conductor hole, and etching said thick Aluminium layer,

Q) depositing a third layer of a third dielectric material, thereby filling said conductor hole.

The substrate preferably is a silicon wafer. The substrate hole is circular shaped.

In a specific embodiment the internal contact is created by flipping said silicon die with an Aluminium pad on its upper surface, said Aluminium pad being covered with an oxide layer. The step of dry etching the silicon die is then performed by etching through the silicon die until the oxide layer is reached. The step of dry etching the first layer of first dielectric material is performed by etching said oxide layer.

In a preferred embodiment the second and the third dielectric material is benzocyclobutene (BCB) and the second layer of said second dielectric material and the third layer of said third dielectric material is deposited by BCB spin coating.

In a further aspect the invention relates to a method for the production of isolated through hole connects in a substrate comprising the steps of:

A) providing a substrate,
B) dry etching said substrate, forming at least one substrate hole,
C) depositing a layer of conducting material on the bottom and on the sidewalls of said substrate hole and possibly on top of the rest of said substrate's surface, thereby transforming said substrate hole into a conductor hole,
D) depositing a positive working photo resist,
E) opening said photo resist at the bottom of said conductor hole,
F) bottom-up electroplating a Cu-post,
G) stripping said photo-resist,
H) stripping said layer of conducting material,
I) depositing a layer of planarising dielectric material, filling the gap between said conductor hole and said Cu-post,
K) depositing and patterning a metal interconnect pattern,
L) depositing a second layer of a second dielectric material,
M) Mechanical back grinding said substrate, such that said substrate is 10 to 50 micrometer thicker than the actual Cu-post,
N) Plasma etching said substrate on the backside, stopping on said Cu-post,
O) Solder ball attachment to said Cu-post.

Advantageously the positive working photo resist is applied by spray-coating or electrophoretic deposition. Possibly the opening of said photo resist is done by UV illumination through a mask.

In a preferred embodiment the additional step is performed of patterning by dry etching said layer of planarising dielectric material, exposing said Cu-post, before applying the step of depositing and patterning a metal interconnect pattern.

In an aspect the invention relates to an alternative method for the production of isolated through hole connects in a substrate, comprising the steps of:

A) provide a substrate,

B) dry etching said substrate, forming at least one substrate hole,
C) depositing a layer of conducting material on the bottom and on the sidewalls of said substrate hole and possibly on top of the rest of said substrate's surface, thereby transforming said substrate hole into a conductor hole,
D) depositing a layer of planarising dielectric material, filling said conductor hole and planarising said substrate,
E) plasma etching in said layer of planarising dielectric material within said conductor hole, until the conducting material at the bottom of said conductor hole is removed, thereby transforming said conductor hole into a dielectric hole,
F) bottom-up electroplating a Cu-post,
G) stripping said layer of planarising dielectric material,
H) stripping said layer of conducting material,
J) depositing and patterning a metal interconnect pattern,
K) depositing a second layer of a second dielectric material,
L) Mechanical back grinding said substrate,
M) Plasma etching said substrate on the backside, stopping on said Cu-post,
N) Etching said layer of conductive material on the back-side of said substrate,
O) Solder ball (8) attachment to said Cu-post.

In a preferred embodiment the photo-patterned dielectric layer is photo benzocyclobutene. Advantageously the additional step is performed of depositing a photo-patterned dielectric layer, with contact openings on said Cu-post, before applying the step of depositing and patterning a metal interconnect pattern.

The substrate preferably is a silicon wafer. The substrate hole typically is circular shaped.

The step of dry etching said substrate is advantageously performed by Reactive Ion Etching - Inductive Coupled Plasma (RIE-ICP). Typically the conducting material is copper. The planarising dielectric material and said second dielectric material is preferably benzocyclobutene (BCB). Preferably said second dielectric material is non-photo benzocyclobutene (BCB). The metal interconnect pattern is formed by semi-additive electroplated copper lines. In the step of plasma etching said substrate on the backside, the substrate is preferably over-etched.

In another aspect the invention relates to a device comprising electrical through hole interconnects fabricated by any of the methods as described above. The invention further relates to a electrical through hole connect, produced by any of the above-described methods.

## Short description of the drawings

Fig. 1 (steps 1A to 1F) illustrates a first embodiment of the present invention. Steps 1G and 1H illustrate preferred further optimal steps of the method of the present invention.

Fig. 2 represents an embodiment with optimal further steps 2G and 2H of the method of the present invention.

Fig. 3 represents an embodiment, wherein the method is also applied on the back side of the substrate.

Fig. 4 represents a sequence of steps according to another embodiment with several layers of dielectric and conducting material.

Fig. 5 represents an alternative to the embodiment of Fig.4.

Fig. 6 represents an embodiment related to chip to wafer bonding.

Fig. 7 represents the steps of an embodiment for a method to create isolated through holes in a substrate.

Fig. 8 represents an alternative method to that described in Fig. 7.

## Detailed description of the invention

The embodiments and examples described below do not limit the scope of the idea and they can be slightly changed by ordinary steps known in the art in order to optimise applicability in specific practical situations. Some preferred practical embodiments are described below.

For the purpose of this invention, the terms 'next layer of dielectric/conducting material' and 'previous layer of dielectric/conducting material' should be understood as the next or previous layer of dielectric/conducting material, respectively, with respect to the moment of deposition. Furthermore the term 'patternable' means that the layer can be patterned. Typically this must be possible at a scale smaller than the hole size. Preferably the patterning of said patternable dielectric material is performed by plasma-etching and/or lithographic techniques. The term 'dielectric hole' is used for a hole whereof the sidewalls are covered with a dielectric material, whereas a 'conductor hole' has sidewalls and bottom covered with a layer of conducting material. The various steps of the method are numbered in capitals, starting from A) . However, it is not always obligatory to perform all steps in alphabetical order, as some steps can constitute an alternative to certain steps that were previously mentioned. The numbering rather refers to that used in the figures.

In a first preferred aspect of the present invention a method is disclosed to make isolated through holes or vias in a substrate. In short through holes are fabricated according to a preferred embodiment as follows :

- dry etching holes in Si-wafer (25 - 50 micron),
- benzocyclobutene (BCB) coating & hole filling,
- dry etching BCB holes concentric to Si-holes (15 - 40 micron),
- depositing seed layer & electroplating thick copper (e.g. 5 - 10 micron),
- providing an additional BCB passivation layer.

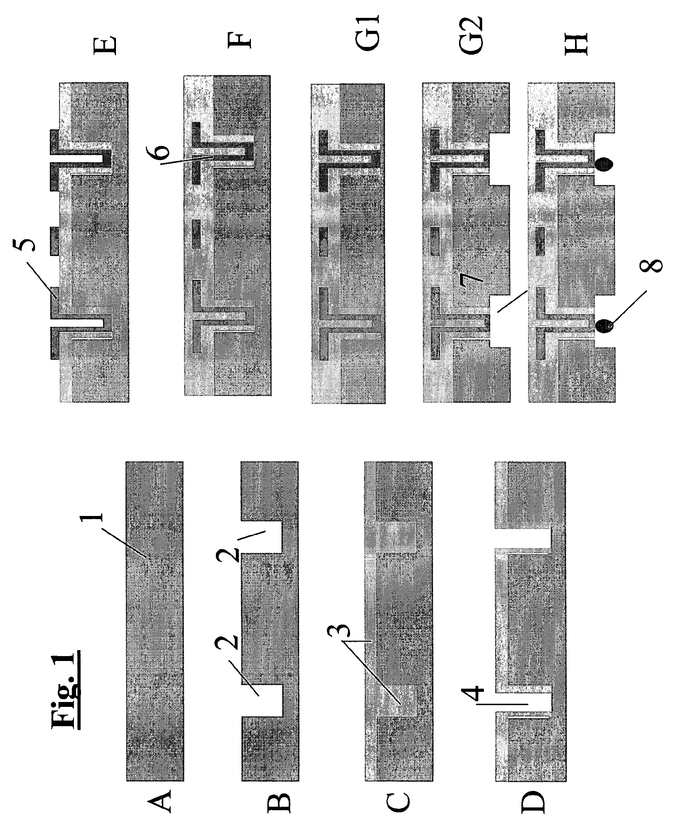

Advantageously another step can be added, namely a step of dry etching Si from the wafer backside, stopping on the copper.
Each step of the method is now described more in detail.
The method preferably comprises the following steps (see Fig.1):

A) Providing a substrate (1) (Fig. 1A); the substrate can be a wafer or a processed wafer. It can be a microelectronics component, possibly bonded to a wafer. Preferably the substrate is a semiconductor substrate. More preferably the substrate is a silicon substrate. Preferably the substrate thickness is between 10 $\mu m$ and 500 $\mu m$. More preferably the substrate thickness is between 20 $\mu m$ and 300 $\mu m$.
B) Dry etching in said substrate, forming at least one substrate hole (2). These substrate holes (2) can have different shapes and dimensions in the same substrate (1). The etching can be performed by different methods known in the state of the art. For instance Reactive Ion Etching - Inductive Coupled Plasma (RIE-ICP) can be used. Preferably these holes are cylindrical, corresponding to a circular opening on the surface (Fig.1B). The holes have a width of 25 $\mu m$, but bigger and smaller holes are possible. Preferably the holes have a width between 20 $\mu m$ and 100 $\mu m$ . Typical holes can have an aspect ratio of 1:5, the aspect ratio being defined as

$$\left.\frac{width}{depth}\right|_{hole}.$$

Aspect ratios of 1:10 or higher are not excluded. A vacuum step can be required to ensure proper filling of the Si substrate holes. For benzocyclobutene (BCB) this is preferably performed at 170°C, as this material exhibits its largest flow at that temperature, before it starts to cure at higher temperatures. An alternative method could be the lamination of a dielectric layer, followed by a vacuum reflow step, filling the holes and planarising the substrate in a single step.
C) depositing a first layer of patternable dielectric material (3) on said substrate (1), whereby said substrate holes (2) are filled and the substrate surface is planarised (Fig.1C). Advantageously the patternable dielectric material is a polymer or silicone. The dielectric material is preferably deposited by spin-coating, spray-coating or lamination techniques. More preferably the patternable dielectric is benzocyclobutene (BCB). Even more preferably non-photo BCB is used for this step, due to its good hole filling and planarisation properties. One or multiple coatings can be required.

D) anisotropically dry etching in the first layer of patternable dielectric material (3) within the substrate hole, forming at least one dielectric hole (4) within the substrate hole (2) (Fig.1D). The sidewalls of the substrate hole (2) hereby remain covered with said first layer of patternable dielectric material (3), until the bottom of said substrate hole (2) is reached. The dielectric hole (4) can have any shape and different shapes of holes can be present in the same dielectric layer. Several dielectric holes (4) can be present in the same substrate hole. Preferably the holes (4) are circular or ring shaped. Preferably the substrate hole (2) and the dielectric hole (4) in the first layer of patternable dielectric material (3) are positioned coaxially.

E) Depositing a layer of conducting material (5) on the bottom and on the sidewalls of the dielectric hole in the layer of patternable dielectric material, whereby the dielectric hole (4) is transformed into a conductor hole (Fig.1E). This step is preferably performed by depositing a seed layer and performing electroplating of the conducting material. This step can cover the whole surface of the wafer. This step may also be performed for instance by Chemical Vapour Deposition (CVD), by Physical Vapour Deposition (PVD), Electro Chemical Deposition (ECD), sputtering techniques as well as by any other method known in the art. Preferably the conducting material (5) is a metal. More preferably the conducting material (5) is copper or aluminium. The step of depositing a conducting material possibly creates an interconnect with an external contact. This step can comprise various substeps. Typically physical vapour deposition (PVD) of e.g. a plating seed layer of 30nm Ti/400 nm Cu is used. The thickness of the Cu on the sidewalls and bottom of the holes may be increased by using electroless Cu plating. This is followed by the deposition of a resist layer, in order to perform pattern plating. After plating the resist and the plating seed layer are stripped from the wafer.

In an alternative embodiment the above-mentioned steps (C), (D), and (E) are replaced by applying Resin Coated Foils, preferably Resin Coated Copper foils. These foils are positioned on top of the substrate, after which they are pressed against the substrate, and thereby fill the hole(s) with a first layer of resin (preferably BCB) and a copper layer.

F) depositing a second layer of a second patternable dielectric material (6) on top of the layer of conducting material (5), hereby filling the gap in the obtained through hole metal fill (Fig.1F). This layer can serve as an external isolation layer. Preferably the second patternable dielectric material is a polymer or silicone. The dielectric material is preferably deposited by spin-coating, spray-coating or lamination techniques. More preferably the second patternable dielectric is benzocyclobutene (BCB) as it has excellent planarisation and gap fill properties. A vacuum step is required to ensure proper filling of the gaps for instance between between the Cu and the Si. For BCB this is preferably performed at $170°C$ as the material exhibits its largest flow at that temperature, before it starts to cure at higher temperatures. Preferably the first (3) and second (6) patternable dielectric material are the same.

For the interconnects, an aspect ratio

$$\left(\text{defined} \quad \text{as} \quad \left.\frac{width}{depth}\right|_{interconnect}\right)$$

of 1:5 even 1:10 is easily achievable. Aspect ratios of 1:20 and more can be achieved.

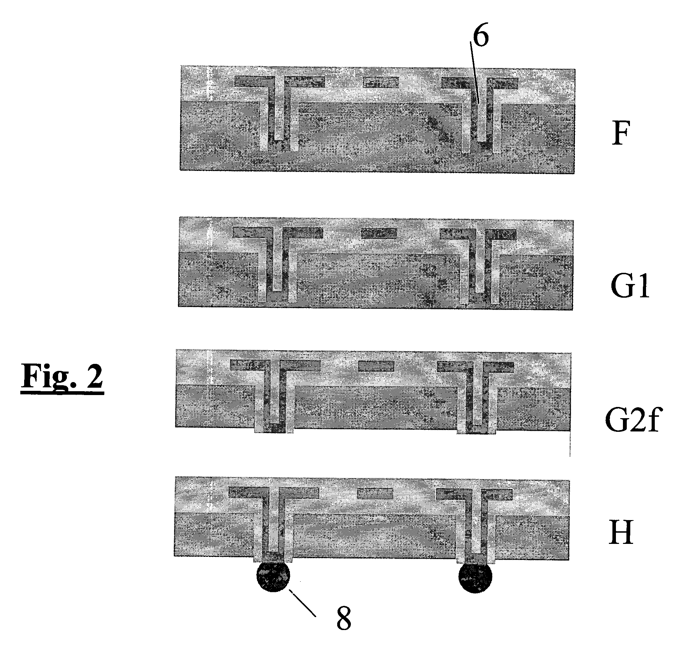

Preferably the present invention further comprises optional steps such as a wafer backgrinding step (Fig.1G1 ≡ Fig.2G1) (preferably until the wafer is $10\mu m$ to $50\mu m$ thicker than the metal via post).

According to a preferred embodiment the optimal steps are :

G) Dry etching or plasma etching the substrate from the backside, hereby possibly creating holes (7) and halting when the conducting material and dielectric material are reached (Fig.1G2). Even more preferably the step of plasma etching does not stop after that the level where the conducting material and dielectric material are reached (for instance copper/BCB plugs), but continues above that level (thus slightly overetching the silicon) (Fig.2G2f). The conducting material and dielectric material will then come out of the etched back surface, which is advantageous for the addition of solder bumps.

H) The addition of solder bumps (8) on the studs of conducting material, for bonding purposes (Fig.1H and Fig.2H).

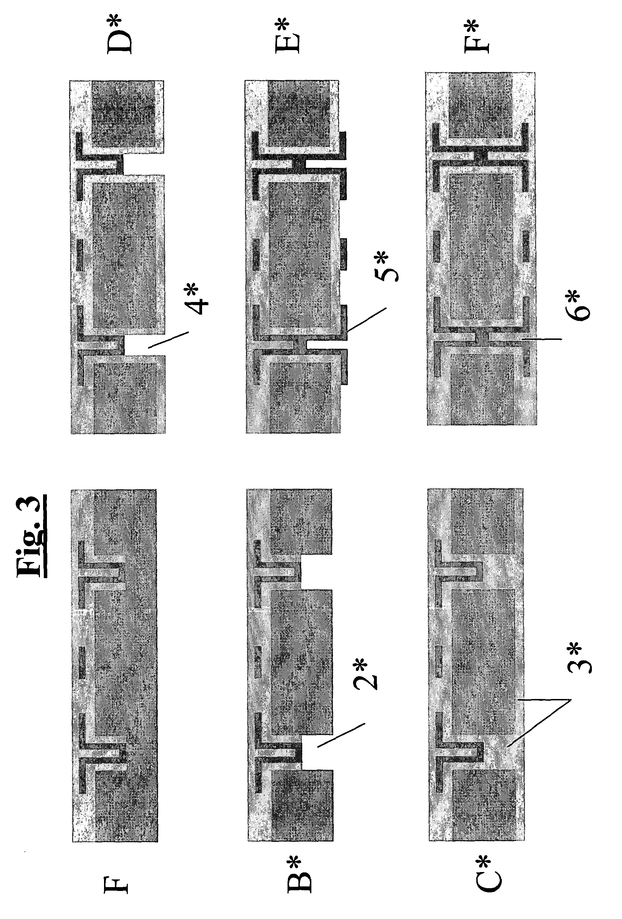

In another embodiment of the present invention (Fig. 3) the method as previously described is applied first on the front side of a substrate (resulting in Fig. 3F ≡Fig. 2F ≡ Fig. 1F), followed by applying the method on the back side (steps B*, C*, D*, E* and F*, respectively), whereby the holes in front and back side (2 and 2*, 4 and 4*, respectively) are co-aligned and 2* is created such that it reaches the conducting material layer (5), such that isolated through hole interconnects are produced passing from the front side of said substrate to the backside of said substrate. Doing so the aspect ratios achievable by a single process can be essentially doubled. For the interconnect aspect ratios of 1:20 are then easily achievable. Aspect ratios of 1:40 and more can even be achieved.

In preferred embodiments different dielectric holes and thus corresponding interconnects are present in one substrate hole and the dielectric holes are made such that a predetermined electromagnetic field is created between the different interconnects when they carry a signal.

In preferred embodiments the interconnect structures are made such that coaxial cable interconnects are produced. Coaxial interconnects that are able to carry signals with frequencies up to 77 GHz and even up to 100 GHz can be achieved when using BCB as dielectric material.

In preferred embodiments N-fold interconnects can be provided by creating ring shaped, coaxial dielectric holes or variations thereof. In typical embodiments N equals 2.

The dielectric holes can be completely filled with conducting material.

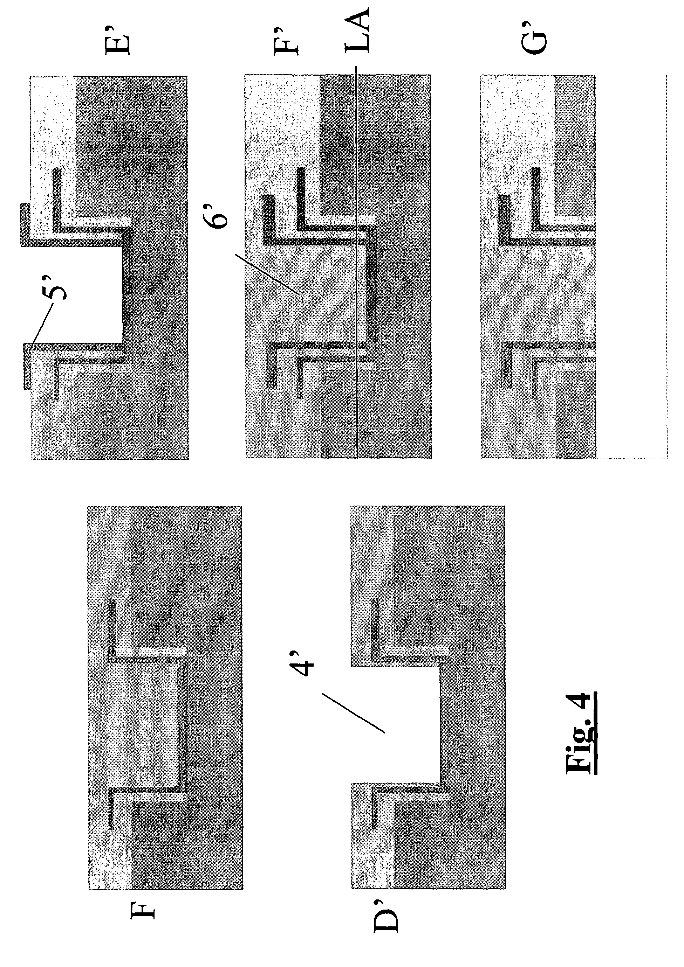

In another embodiment of the present invention (Fig. 4), the method comprises -starting from the situation in Fig.4F- the further steps:

I) anisotropically dry etching in the previous layer of patternable dielectric material within a previous conductor hole formed by a previous layer of conductive material, such that at least one dielectric hole (4') is formed within the previous conductor hole. The sidewalls of the previous conductor hole remain covered with the previous layer of patternable dielectric material, until the bottom of said previous conductor hole is reached. (Fig.4D')

J) depositing a next layer of conducting material (5') on the bottom and on the sidewalls of said dielectric hole in said previous layer of patternable dielectric material, thereby transforming the dielectric hole (4') into a conductor hole (Fig.4E'). This step (j) can create an interconnection with an external contact.

K) depositing a next layer of a further patternable dielectric material (6') on top of said next layer of conducting material deposited in the previous step (Fig.4F'). An additional step of thinning the substrate from the back side up until a level LA is reached, is preferred (Fig.4G'). The level LA must be high enough such that the material on the bottom of the different layers of conducting material are removed. This way the invention allows making 'coaxial cable' interconnects.

According to another embodiment of the present invention, the set of steps (I, J, K) are repeated for a finite integer number of times N, such that N-fold electrical interconnects are produced. An additional step of thinning the substrate from the back side until at least a level LA is reached is preferred. This way the invention allows making N-fold 'coaxial cable' interconnects.

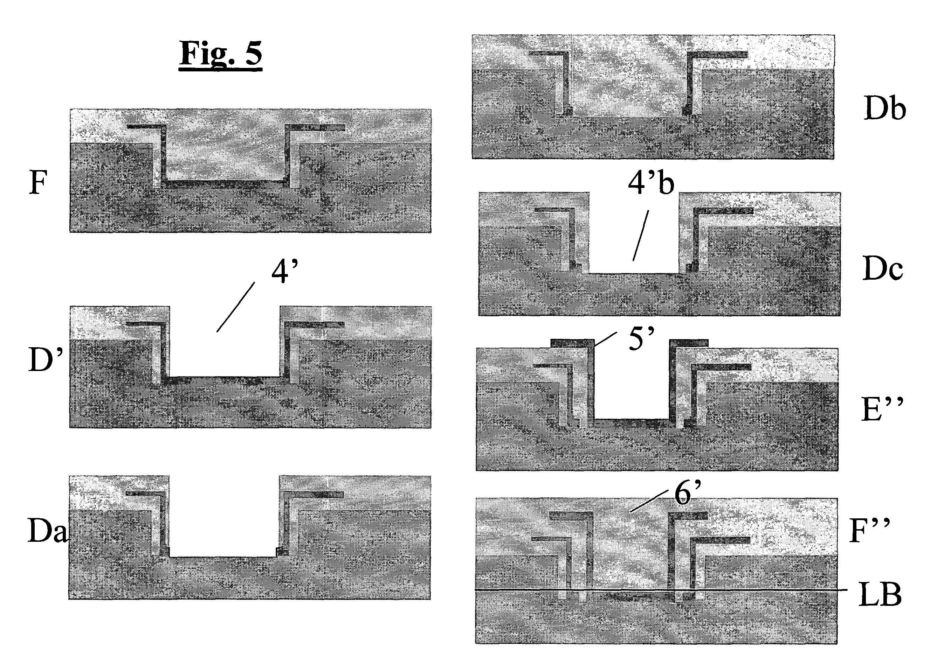

According to another embodiment of the present invention represented in Fig. 5, the method comprises -starting from the situation in Fig.5F- the further steps:

L) Anisotropically dry etching in the previous layer of patternable dielectric material within the previous conductor hole formed by the previous layer of conductive material, forming at least one dielectric hole (4') within said previous conductor hole. The sidewalls of the previous conductor hole remain covered with said previous patternable dielectric material, until the bottom of the previous conductor hole is reached (Fig.5D').

M) Removing the conducting material from the bottom of the dielectric hole until the substrate material is reached on the bottom of the dielectric hole (Fig. 5Da).

N) Depositing a next layer of a further patternable dielectric material, whereby the dielectric hole is filled (Fig.5Db).

O) Anisotropically dry etching in the next layer of patternable dielectric material within the dielectric hole, forming a new dielectric hole (4'b) within the dielectric hole (4') such that the remains of the dielectric hole (4') remain covered with the next layer of patternable dielectric material, until the bottom of the substrate holes is reached (Fig.5Dc).

P) Depositing a next layer of conducting material (5') on the bottom and on the sidewall of said new dielectric hole (4'b) in said next layer of patternable dielectric material, thereby transforming said new dielectric hole (4'b) into a conductor hole (Fig.5E'').

Q) Depositing a next layer (6') of a further patternable dielectric material on top of said next layer of conducting material (5') (Fig.5F'').

An additional step of thinning the substrate from the back side up until a level LB is reached is preferred. The level LB must be high enough such that the material on the bottom of the different layers of conducting material are removed. This way the invention again allows making 'coaxial cable' interconnects.

According to another embodiment of the present invention, the set of steps (L, M, N, O, P, Q) according to the previous embodiment can also be repeated for a finite integer number of times (*n*), such that *n*-fold electrical interconnects can be produced.

An additional step of thinning the substrate from the back side up until a level LB is reached is preferred. Step (P) can advantageously create an interconnection with an external contact. This way the invention allows again making n-fold 'coaxial cable' interconnects.

The present invention offers different advantages. It allows the production of multiple metal connections through a single Si hole. For example it allows for radio frequency (RF) coax transitions.

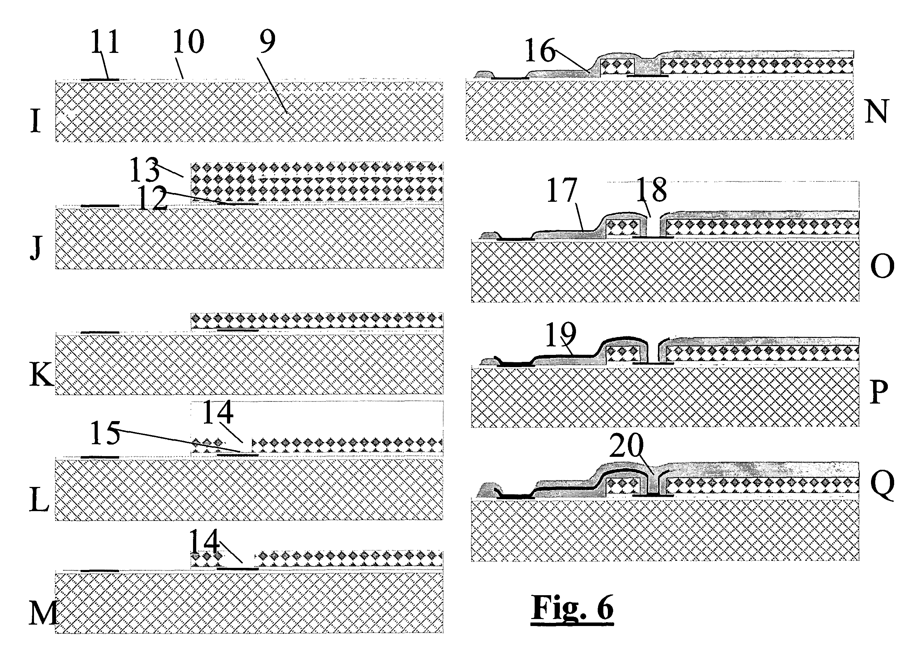

Another aspect of the present invention is related to chip to wafer bonding and more specifically to an interconnect scheme for already bonded chips. It comprises the following steps (Fig. 6):

I) providing a substrate (9), e.g. a silicon wafer, typically covered by an oxide layer (10), which comprises an open contact (11) (Fig. 6I),

J) Performing silicon die (13) to wafer bonding next to the open contact, whereby the silicon die has an internal contact (12) or an internal contact (12) is created. For example, the internal contact can be created by flipping a die with an Aluminum pad on its upper surface (Fig. 6J), which is typically first covered with an oxide layer. The internal contacts are typically isolated by a first layer of dielectric material,

K) Thinning the bonded die on wafer level. Hereby the internal contact is not revealed (Fig. 6K),

L) Dry etching in the thin Si-die (14), forming a preferably circular substrate hole (20-40 micron diameter), until the dielectric isolation layer of the internal contact is reached. In the flip-chip example this means etching through the die until the oxide layer covering the Al pads (15) is reached (Fig. 6L),

M) Etching the first layer of dielectric material, which is isolating the internal contact, at the bottom of the substrate hole. In the flip-chip example this means etching the oxide layer covering the Al pads (15) (Fig. 6M),

N) BCB spin coating on wafer level, hereby filling the substrate hole(s) (14) and creating a layer of BCB (16) (Fig. 6N),

O) Depositing and patterning a thin Aluminum hardmask layer (17) (Fig. 6O), and dry etching in the layer of BCB (18) within the substrate hole in the die, forming a dielectric hole (10-20 micron diameter) within said substrate hole, whereby the sidewalls of the substrate hole remain covered with BCB, until the bottom of said substrate holes is reached (Fig. 6O),

P) Depositing a thick Aluminum layer (19) with good step coverage. This step is creating the interconnect between the open contact (11) and the internal contact (12), thereby transforming the dielectric hole into a conductor hole (Fig. 6P), and etching the thick Aluminum layer (19),

Q) Depositing an additional BCB passivation layer (20) by spin coating BCB, thereby filling the conductor hole (Fig. 6Q).

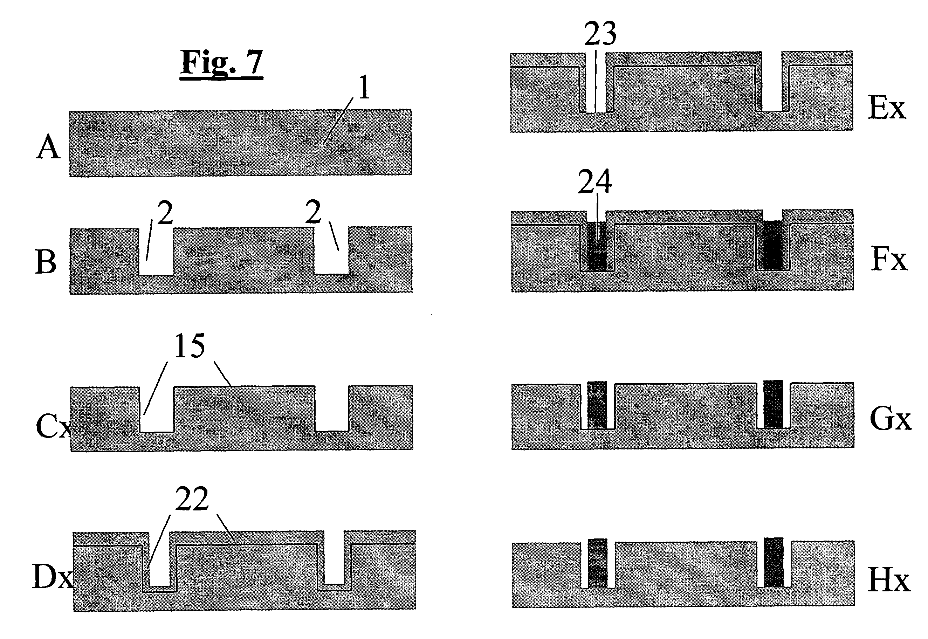

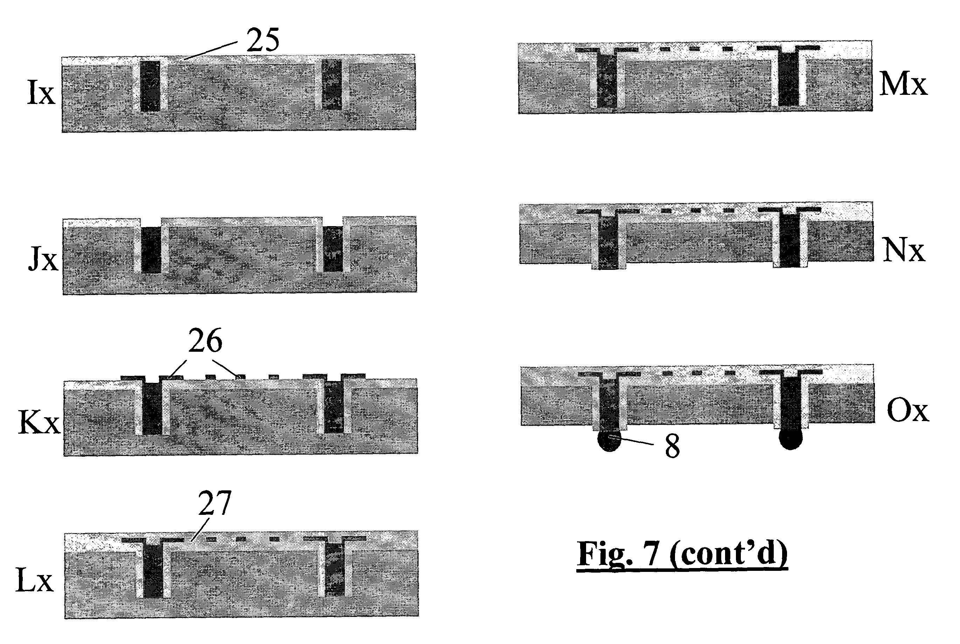

According, to another aspect the invention also relates to a method for making isolated through holes or vias in a substrate. The method comprises according to a preferred embodiment the following steps (Fig.7):

A) Providing a substrate (1), preferably a Si wafer, possibly a processed substrate (Fig.7A)

B) dry etching said substrate, typically by RIE-ICP, forming at least one substrate hole (2). Advantageously the substrate hole is cylindrical, but other shapes are also possible. A typical hole will have a diameter of 20 to 100 micrometer and an aspect ratio (width to depth) of up to 1:5. (Fig.7B)

C) Depositing a layer of conducting material (15) on the sidewalls and the bottom of the substrate hole (s), thereby transforming said substrate hole (2) into a conductor hole, and on the rest of the wafer surface. The step is preferably performed by depositing a seed layer and performing electroplating of the conducting material. Typically physical vapour deposition (PVD) of e.g. 30nm Ti/400 nm Cu will be used, Cu being a preferable conducting material. Aluminium is an alternative conducting material. The thickness of the Cu on the sidewalls and bottom of the holes may be increased by using electroless Cu plating. (Fig.7Cx)

D) Depositing a positive working photo resist (22). This layer can be applied by spin-coating, but the application by spray-coating or electrophoretic deposition is to be preferred. A typical thickness of this resist is 5 to 10 micrometer. (Fig.7Dx)

E) Opening the photo resist (22) at the bottom (23) of the hole by UV illumination through a mask. (Fig. 7Ex)

F) Bottom-up electroplating a Cu-post (24), with a thickness approximately equal to the depth of the Si hole. In case of a cylindrical hole, this is a Cu cylinder. (Fig.7Fx)

G) Stripping the photo-resist layer. (Fig.7Gx)

H) Stripping the seed layer (conducting material layer) by wet chemical etching. During this etch the Cu via-fill can be slightly etched-back. (Fig.7Hx)

I) Depositing a layer of planarising dielectric material (25), filling the gap between the Si substrate and the Cu post (Fig.7Ix). A preferred dielectric for this application is BCB, as it has excellent planarisation and gap fill properties. A vacuum step is required to ensure proper filling of the gaps between the Cu and the Si. For BCB this is preferably performed at 170°C as the materials exhibits its largest flow at that temperature, before it starts to cure at higher temperatures.

J) Patterning by dry etching said layer of planarising dielectric material (25), exposing the Cu-post structures (Fig.7Jx). If the layer in I is photo-defined BCB, this step is not required.

K) Depositing and patterning a metal interconnect pattern (26) (Fig.7Kx). This could e.g. be semi-additive electroplated Cu lines. Other metals and methods are however also feasible, e.g. deposition by PVD of Cu, Al, Pt,... and patterning by wet-etching or lift-off.

L) Depositing a second layer (27) of a second dielectric material as a passivation layer (Fig.7Lx). This is preferably a second BCB coating. Other materials, inorganic or organic could also be used.

M) Mechanical back grinding the wafers, such that the substrate is 10 to 50 micrometer thicker than the actual Cu via post (Fig.7Mx),

N) Plasma etching the substrate backside, stopping on the Cu/BCB plug and slightly over-etching the silicon (Fig.7Nx),

O) Solder ball (8) attachment to the Cu studs. (Fig. 7Ox)

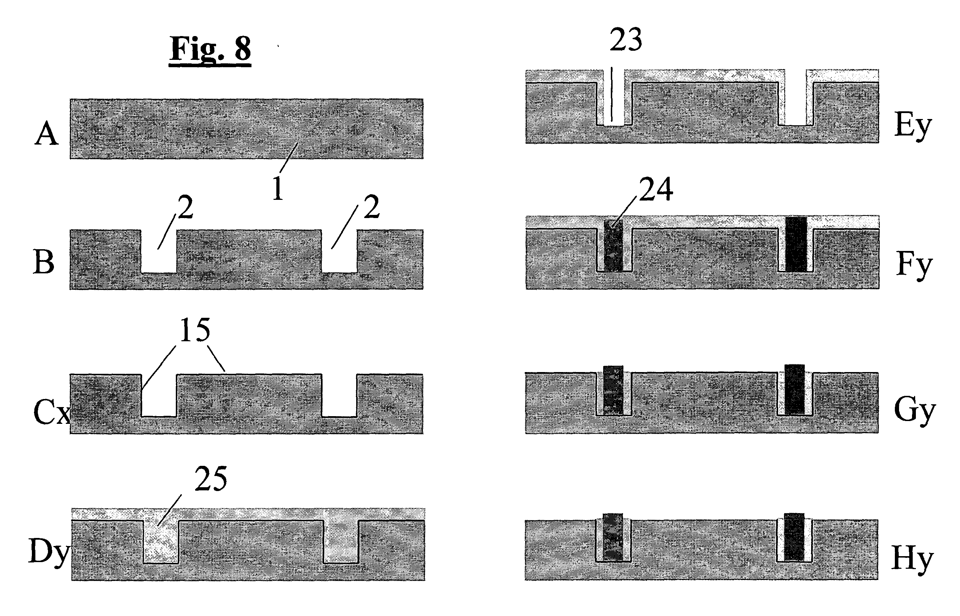

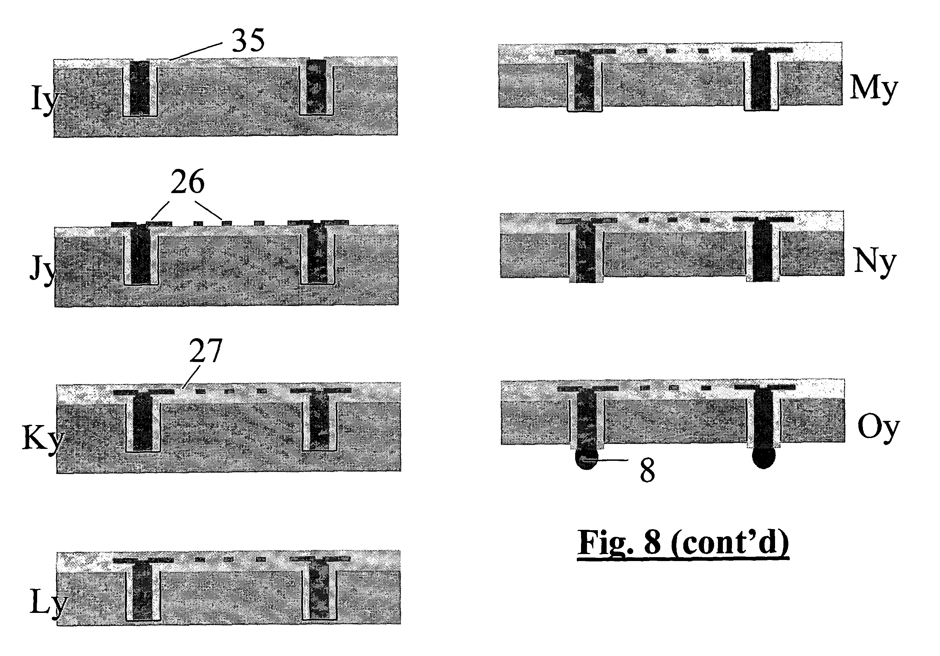

An alternative method to make isolated through holes or vias in a substrate comprises the following steps (Figure 8). The first three steps are as described above.

A) providing a substrate (1), preferably a Si wafer, possibly a processed Si wafer (Fig.8A),

B) dry etching said substrate, typically by RIE-ICP, forming at least one substrate hole (2). Advantageously the substrate hole is cylindrical, but other shapes are also possible. A typical hole will have a diameter of 20 to 100 micrometer and an aspect ratio (width to depth) of up to 1:5 (Fig.8B).

C) depositing a layer of conducting material (15) on the sidewalls and the bottom of the substrate hole (s), thereby transforming said substrate hole (2) into a conductor hole, and possibly on the rest of the wafer surface. The step is preferably performed by depositing a seed layer and performing electroplating of the conducting material. Typically physical vapour deposition (PVD) of e.g. 30nm Ti/400nm Cu will be used, Cu being a preferable conducting material. The thickness of the Cu on the sidewalls and bottom of the holes may be increased by using electroless Cu plating. In order to avoid any contamination of the Si substrate from the Cu metallisation, a TaN barrier layer can be used instead of the Ti seed layer base (Fig.8C).

D) depositing a planarising dielectric layer (25), filling the conductor holes and planarising the substrate. Preferably non-photo BCB is used for this step, due to its good hole-filling and planarising properties. One or multiple coatings could be required. A vacuum step is required to ensure proper filling of the Si holes. For BCB this is preferably performed at 170°C, as this material exhibits its largest flow at that temperature, before it starts to cure at higher temperatures. An alternative method could be the lamination of a dielectric layer, followed by a vacuum reflow step, filling the holes and planarising the substrate in a single step (Fig.8Dy).

E) plasma etching in the BCB-via fill until the conducting material (15) at the bottom (23) of the conductor hole is removed, thereby transforming the conductor hole into a dielectric hole (Fig.8Ey). The hole may be concentric to the Si-etched hole or have arbitrary shapes (multiple holes in a single Si trough-hole).

F) bottom-up electroplating a Cu-post (24), with a thickness about equal to the depth of the Si hole. In the case of a cylindrical hole, this is a Cu cylinder (Fig.8Fy).

G) stripping the top BCB layer by plasma etching (Fig.8Gy),

H) stripping the layer of conducting material (the exposed seed-layer) by wet chemical etching. During this etch the Cu via-fill will be slightly etched-back (Fig.8Hy).

I) depositing a photo-patterned dielectric layer (35), with contact openings on the Cu trough-hole fills (Fig.8Iy). A preferred dielectric for this application is photo-BCB. Patterning by dry etching of the BCB layer, exposing the Cu-fill structures. If the layer in I is photo-defined BCB, this step will not be required.

J) depositing and patterning a metal interconnect pattern (26). This could e.g. be semi-additive electroplated Cu lines. Other metals and methods are however also feasible, e.g. deposition by PVD of Cu, Al, Pt,... and patterning by wet-etching or lift-off. (Fig.8Jy)

K) depositing a second layer (27) of a second dielectric material as a passivation layer. This is preferably a BCB coating. Other materials, inorganic or organic could also be used. (Fig.8Ky)

L) Mechanical back grinding the wafers, 10 to 50 micrometer thicker than the actual Cu via post. (Fig. 8Ly)

M) Plasma etching the backside of the wafer, stopping on the Cu/BCB plug and slightly over-etching the silicon. (Fig.8My)

N) Wet etching of the exposed conductive layer (seed layer) on the back-side of the thinned wafer. During this etch the Cu via-fill will be slightly etched-back. In this case, the seed layer remains present on the sidewalls of the Silicon via hole. (Fig.8Ny)

O) Solder ball (8) attachment to the Cu studs. (Fig. 8Oy)

Polymers like BCB can be deposited at relatively low temperatures, when compared to for instance CVD Si oxide deposition. A typical prior art CVD Silicon oxide deposition step in order to create isolated through holes, is limited moreover by the characteristic of bad step coverage properties. Silicon oxide deposition produces layers with about uniform thickness, which limits design freedom. Silicon oxide can easily build up stress and is not flexible.

BCB is patternable, since it is for instance anisotropically dry or plasma-etchable. BCB is easy to process and spin and spray coatable. It has good planarization properties. BCB is flexible and low stress formation appears. BCB provides a large design freedom. Water absorption is low. Adhesion properties to substrate and conductor are present. Other properties of BCB can be found in Burdeaux et al., "Benzocyclobutene (BCB) Dielectrics for the Fabrication of High Density, Thin Film Multichip Modules.", journal of Electronic materials, Vol. 19, No. 12, 1990.

The thermo-mechanical properties of polymers and silicones are such that "flexible" and less fragile structures, more specifically interconnect structures can be created. The invention allows smaller pitch and thus higher density interconnects. The method according to the present invention provides quicker, easier and cheaper processing.

**Claims**

1. Method for the fabrication of a device comprising electrical through hole interconnects, comprising the following steps:

   (A) providing a substrate (1),
   (B) dry etching said substrate (1), forming at least one substrate hole (2),
   (C) depositing a first layer of a first patternable dielectric material (3) on said substrate, said substrate hole (2) thereby being filled,
   (D) anisotropically dry etching in said first layer of patternable dielectric material (3) within said substrate hole (2), forming at least one dielectric hole (4) within said substrate hole (2), whereby the sidewalls of said substrate hole (2) remain covered with said first layer of a first patternable dielectric material (3), until the bottom of said substrate hole (2) is reached,
   (E) depositing a layer of conducting material (5) on the bottom and on the sidewalls of said dielectric hole (4), thereby transforming said dielectric hole (4) into a conductor hole.
   (F) depositing a second layer of a second patternable dielectric material (6) on top of said layer of conducting material (5), said conductor hole being filled.

2. Method according to claim 1, wherein at least two of said dielectric holes (4) within the same said substrate hole (2) define interconnects, between which a predetermined electromagnetic field is created when they carry a signal.

3. Method according to claim 2, wherein said dielectric holes (4) within the same said substrate hole (2) define an N-fold coaxial cable interconnect.

4. Method according to claim 3, wherein N equals 2.

5. Method according to any of claims 1 to 4, further comprising a step of

(G) dry etching said substrate (1) from the backside, until said conducting material (5) is reached.

6. Method for the fabrication of a device comprising electrical through hole interconnects, comprising the steps of

   - performing the method according to any of claims 1 to 5 on the front side of said substrate (1) , forming at least one substrate hole in said front side (2), and
   - performing the method on the back side of said substrate (1), forming at least one substrate hole in said back side (2*), said substrate hole in said back side (2*) being aligned with said substrate hole in said front side (2), thereby producing isolated through hole interconnects passing from said front side of said substrate (1) to said backside of said substrate (1).

7. Method according to claim 1, further comprising the steps of:

   (I) anisotropically dry etching in a previous layer of patternable dielectric material within a previous conductor hole formed by a previous layer of conductive material, forming at least one dielectric hole (4') within said previous conductor hole, whereby the sidewalls of said previous conductor hole remain covered with said previous layer of patternable dielectric material, until the bottom of said previous conductor hole is reached,
   (J) depositing a next layer of conducting material (5') on the bottom and on the sidewalls of said dielectric hole (4') in said previous layer of patternable dielectric material, thereby transforming said dielectric hole (4') into a conductor hole,
   (K) depositing a next layer of a further patternable dielectric material (6') on top of said next layer of conducting material (5'), said conductor hole thereby being filled.

8. Method according to claim 1, further comprising the steps of:

   (L) anisotropically dry etching in a previous layer of patternable dielectric material within a previous conductor hole formed by a previous layer of conductive material, forming at least one dielectric hole (4') within said previous conductor hole, whereby the sidewalls of said previous conductor hole remain covered with said previous patternable dielectric material, until the bottom of said previous conductor hole is reached,
   (M) removing said conducting material from the bottom of said dielectric hole until said substrate (1) is exposed on the bottom of said dielectric hole,

(N) depositing a next layer of a further patternable dielectric material, whereby said dielectric hole is filled,

(O) anisotropically dry etching in said next layer of patternable dielectric material within said dielectric hole, forming a new dielectric hole (4'b) within said dielectric hole (4'), whereby the remains of said dielectric hole (4') remain covered with said next layer of patternable dielectric material, until the bottom of said substrate hole is reached,

(P) depositing a next layer of conducting material (5') on the bottom and on the sidewalls of said new dielectric hole (4'b) in said next layer of patternable dielectric material, thereby transforming said new dielectric hole (4'b) into a conductor hole,

(Q) depositing a next layer of a further patternable dielectric material (6') on top of said next layer of conducting material (5').

9. Method for the fabrication of devices comprising multilevel electrical through hole interconnects according to claim 7, **characterised in that** it reapplies the further steps (I,J,K) for a finite number of times and whereby optionally the backside of said substrate (1) is thinned up until a level (LA) high enough such that the conducting material on the bottom of said layers of conducting material is removed.

10. Method for the fabrication of devices comprising multilevel electrical through hole interconnects according to claim 9, **characterised in that** it reapplies the further steps (L,M,N,O,P,Q) for a finite integer number of times and whereby optionally the backside of said substrate is thinned up until a level (LB) high enough such that the conducting material on the bottom of said layers of conducting material is removed.

11. Method according to claim 1 to 10 wherein said conducting material (5) is copper.

12. Method according to claim 1 to 11, whereby any of the steps (E), (J) or (P) creates an interconnection with an external contact.

13. Method according to claim 1 to 12, wherein said first dielectric material, said second dielectric material and further dielectric materials are chosen from the group [polymer, silicone].

14. Method according to claim 13, whereby said polymer is benzocyclobutene.

15. Method according to claim 14, wherein said first dielectric material, said second and said further dielectric materials are deposited by spin coating or spray coating or lamination.

16. Method according to claim 1 to 15, wherein said first dielectric material, said second dielectric material and said further dielectric materials are the same.

17. Method according to claim 1 to 16, wherein said substrate (1) is a processed substrate.

18. Method according to claim 1 to 17, wherein said substrate (1) is a semiconductor substrate.

19. Method according to claim 18, wherein said substrate (1) is a silicon substrate.

20. Method according to claim 1 to 19, wherein said substrate hole (2) is circular shaped.

21. Method according to claim 1 to 20, wherein said dielectric hole (4) is circular or ring shaped.

22. Method according to claim 1 and 21, wherein said dielectric hole (4) and said substrate hole (2) are concentric.

23. Method according to claim 1 to 22, wherein the width of said dielectric hole (4) is between 15 $\mu$m and 40$\mu$m.

24. Method according to claim 1 to 23, whereby patterning of said patternable dielectric material (6) is performed by plasma-etching or lithography techniques.

25. Method for the fabrication of a device comprising electrical through hole interconnects, comprising the steps of:

I) providing a substrate (9), typically covered by an oxide layer (10) and comprising an open contact (11),

J) bonding a silicon die (13) to said substrate, whereby said silicon die (13) has an internal contact or an internal contact is created, said internal contact being isolated by a first layer of a first dielectric material,

K) thinning said bonded silicon die (13) without revealing said internal contact (12),

L) dry etching said silicon die (13), forming at least one substrate hole (14), until said first layer of said first dielectric material in said internal contact is reached,

M) dry etching said first layer of said first dielectric material at the bottom of said substrate hole (14),

N) depositing a second layer (16) of a second dielectric material, said substrate hole (14) thereby being filled,

O) depositing and patterning a thin metal hardmask layer (17), and dry etching in said second layer of said second dielectric material within said substrate hole in said silicon die, forming a dielectric hole (18) within said substrate hole, whereby the sidewalls of said substrate hole remain covered with said second layer of said second dielectric material, until the bottom of said substrate hole is reached,

P) depositing a thick metal layer (19), creating an interconnect between said open contact (11) and said internal contact (12), thereby transforming said dielectric hole into a conductor hole, and etching said thick metal layer (19),

Q) depositing a third layer (20) of a third dielectric material, thereby filling said conductor hole.

26. Method according to claim 25, wherein said substrate (9) is a silicon wafer.

27. Method according to claim 25 or 26, wherein said substrate hole (2) is circular shaped.

28. Method according to any of claims 25 to 27, wherein said internal contact is created by flipping said silicon die with a metal pad on its upper surface, said metal pad being covered with an oxide layer.

29. Method according to any of claims 25 to 28, wherein said metal is Aluminium.

30. Method according to claim 28, wherein the step of dry etching said silicon die (13) is performed by etching through said silicon die until said oxide layer is reached.

31. Method according to claim 30, wherein the step of dry etching said first layer of first dielectric material is performed by etching said oxide layer.

32. Method according to any of claims 25 to 31, wherein said second dielectric material and said third dielectric material is benzocyclobutene (BCB) and said second layer of said second dielectric material and said third layer of said third dielectric material is deposited by BCB spin coating.

33. Method for the production of isolated through hole connects in a substrate comprising the steps of:

J) providing a substrate (1),
K) dry etching said substrate (1), forming at least one substrate hole (2),
L) depositing a layer of conducting material (15) on the bottom and on the sidewalls of said substrate hole (2) and possibly on top of the rest of said substrate's surface, thereby transforming said substrate hole (2) into a conductor hole,
M) depositing a positive working photo resist (22),
N) opening said photo resist (22) at the bottom (23) of said conductor hole,
O) bottom-up electroplating a Cu-post (24),
P) stripping said photo-resist (22),
Q) stripping said layer of conducting material (15),
R) depositing a layer of planarising dielectric material (25), filling the gap between said conductor hole and said Cu-post,
P) depositing and patterning a metal interconnect pattern (26),
Q) depositing a second layer (27) of a second dielectric material,
R) Mechanical back grinding said substrate, such that said substrate is 10 to 50 micrometer thicker than the actual Cu-post,
S) Plasma etching said substrate on the backside, stopping on said Cu-post,
T) Solder ball (8) attachment to said Cu-post.

34. Method according to claim 33, wherein said positive working photo resist (22) is applied by spray-coating or electrophoretic deposition.

35. Method according to claim 33, wherein the additional step is performed of patterning by dry etching said layer of planarising dielectric material, exposing said Cu-post, before applying the step of depositing and patterning a metal interconnect pattern.

36. Method for the production of isolated through hole connects in a substrate comprising the steps of:

I) provide a substrate (1),
J) dry etching said substrate (1), forming at least one substrate hole (2),
K) depositing a layer of conducting material (15) on the bottom and on the sidewalls of said substrate hole (2) and possibly on top of the rest of said substrate's surface, thereby transforming said substrate hole (2) into a conductor hole,
L) depositing a layer of planarising dielectric material (25), filling said conductor hole and planarising said substrate,
M) plasma etching in said layer of planarising dielectric material (25) within said conductor hole, until the conducting material (15) at the bottom (23) of said conductor hole is removed, thereby transforming said conductor hole into a dielectric hole,
N) bottom-up electroplating a Cu-post (24),
O) stripping said layer of planarising dielectric material (25),

P) stripping said layer of conducting material (15),

P) depositing and patterning a metal interconnect pattern (26),

Q) depositing a second layer (27) of a second dielectric material,

R) Mechanical back grinding said substrate,

S) Plasma etching said substrate on the back-side, stopping on said Cu-post,

T) Etching said layer of conductive material (15) on the back-side of said substrate,

U) Solder ball (8) attachment to said Cu-post.

37. Method according to claim 36, wherein said photo-patterned dielectric layer is photo benzocyclobutene (BCB).

38. Method according to claim 36, wherein the additional step is performed of depositing a photo-patterned dielectric layer (35), with contact openings on said Cu-post (24), before applying the step of depositing and patterning a metal interconnect pattern.

39. Method according to claim 33 or 36, wherein said substrate (1) is a silicon wafer.

40. Method according to claim 33 or 36, wherein said substrate hole (2) is circular shaped.

41. Method according to claim 33 or 36, wherein said conducting material (15) is copper.

42. Method according to claim 33 or 36, wherein said planarising dielectric material (25) and said second dielectric material (27) is benzocyclobutene (BCB).

43. Method according to claim 33 or 36, wherein said metal interconnect pattern (26) is formed by semi-additive electroplated copper lines.

44. Method according to claim 33 or 36, wherein in the step of plasma etching said substrate on the back-side, said substrate is over-etched.

45. Device comprising electrical through hole interconnects fabricated by any of the methods according to claim 1 to 44.

46. Electrical through hole connect produced by any of the methods according to claim 1 to 44.

EP 1 519 410 A1

**Fig. 1**

A — 1

B — 2   2

C — 3

D — 4

E — 5

F — 6

G1

G2 — 7

H — 8

**Fig. 2**

**Fig. 3**

F

D*

4*

B*

E*

2*

5*

C*

F*

3*

6*

EP 1 519 410 A1

Fig. 4

# Fig. 5

F

D'

4'

Da

Db

4'b

Dc

5'

E''

6'

F''

LB

EP 1 519 410 A1

**Fig. 6**

EP 1 519 410 A1

**Fig. 7**

A — 1

B — 2 ... 2

Cx — 15

Dx — 22

Ex — 23

Fx — 24

Gx

Hx

EP 1 519 410 A1

Fig. 7 (cont'd)

**Fig. 8**

A

B

Cx

Dy

Ey

Fy

Gy

Hy

1

2    2

15

25

23

24

EP 1 519 410 A1

Fig. 8 (cont'd)

## EUROPEAN SEARCH REPORT

| | European Patent Office | | Application Number |
|---|---|---|---|
| | | | EP 03 44 7236 |

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | PATENT ABSTRACTS OF JAPAN vol. 2000, no. 16, 8 May 2001 (2001-05-08) & JP 2001 015654 A (HITACHI LTD), 19 January 2001 (2001-01-19) <br><br> * abstract; figures 1-5,13-18 * | 1,6, 11-13, 15-17, 20,21, 24,45,46 | H01L21/768 H01L23/48 |
| X | PATENT ABSTRACTS OF JAPAN vol. 1999, no. 14, 22 December 1999 (1999-12-22) & JP 11 251316 A (TOSHIBA CORP), 17 September 1999 (1999-09-17) | 45,46 | |
| A | * abstract * | 1-32 | |
| A | US 2002/027293 A1 (HOSHINO MASATAKA) 7 March 2002 (2002-03-07) * paragraph [0050] - paragraph [0060]; figures 10-21 * | 1-32,45, 46 | |
| A | US 2002/017710 A1 (ITO HARUKI ET AL) 14 February 2002 (2002-02-14) * paragraph [0098] - paragraph [0137]; figures 1-3 * | 1-32,45, 46 | TECHNICAL FIELDS SEARCHED (Int.Cl.7) H01L |
| A | US 2002/048916 A1 (YANAGIDA TOSHIHARU) 25 April 2002 (2002-04-25) * paragraphs [0055] - [0065]; figures 5,6 * | 1-32,45, 46 | |
| A | PATENT ABSTRACTS OF JAPAN vol. 011, no. 099 (E-493), 27 March 1987 (1987-03-27) & JP 61 248534 A (TOSHIBA CORP), 5 November 1986 (1986-11-05) * abstract * | 1-7 | |

~~The present search report has been drawn up for all claims~~

| Place of search | Date of completion of the search | Examiner |
|---|---|---|
| The Hague | 9 March 2004 | Ploner, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent

Office

---

## CLAIMS INCURRING FEES

*The present European patent application comprised at the time of filing more than ten claims.*

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1-32,45,46

**European Patent Office**

**LACK OF UNITY OF INVENTION
SHEET B**

Application Number

EP 03 44 7236

The Search Division considers that the present European patent application does not comply with the requirements of unity of invention and relates to several inventions or groups of inventions, namely:

1. claims: 1-32, 45, 46

    Method of forming coaxial through hole interconnects

1.1. claims: 1-24, 45, 46

        Method of metallizing a hole in a substrate

1.2. claims: 25-32,45,46

        Method of electrically connecting a silicon die to a
        substrate and device formed by said method
        ---

2. claims: 33-44, 45, 46

        Method of forming a through-hole interconnect by selective
        plating in a substrate hole and device formed by said method
        ---

Please note that all inventions mentioned under item 1, although not necessarily linked by a common inventive concept, could be searched without effort justifying an additional fee.

## ANNEX TO THE EUROPEAN SEARCH REPORT
## ON EUROPEAN PATENT APPLICATION NO.

EP 03 44 7236

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2004

| Patent document cited in search report | | Publication date | Patent family member(s) | | Publication date |
|---|---|---|---|---|---|
| JP 2001015654 | A | 19-01-2001 | NONE | | |
| JP 11251316 | A | 17-09-1999 | NONE | | |
| US 2002027293 | A1 | 07-03-2002 | JP | 2003017558 A | 17-01-2003 |
| US 2002017710 | A1 | 14-02-2002 | JP<br>CN | 2002050738 A<br>1338775 A | 15-02-2002<br>06-03-2002 |
| US 2002048916 | A1 | 25-04-2002 | JP<br>US | 2000277689 A<br>6429096 B1 | 06-10-2000<br>06-08-2002 |
| JP 61248534 | A | 05-11-1986 | NONE | | |

For more details about this annex : see Official Journal of the European Patent Office, No. 12/82